# EUROPEAN PATENT APPLICATION

(11) **EP 4 181 646 A1**
(43) Date of publication of application: **17.05.2023**
(21) Application number: 21837978.2
(22) Date of filing: 17.06.2021
(51) Int. Cl.: H05K 13/02

(54) **STORAGE CASE**

(30) Priority: 07.07.2020 JP 2020117206
(71) Applicant: Murata Manufacturing Co., Ltd., Nagaokakyo-shi, Kyoto 617-8555 (JP)
(72) Inventor: SHIMIZU Yasuhiro, Nagaokakyo-shi, Kyoto 617-8555 (JP); NAKAGAWA Kiyoyuki, Nagaokakyo-shi, Kyoto 617-8555 (JP)
(74) Representative: Zimmermann, Tankred Klaus
(86) International application number: PCT/JP2021/023093
(87) International publication number: WO 2022/009646

(57) **Abstract**

The present invention provides a storage case that, regardless of the number of electronic components stored therein, prevents a component takeout port from being easily clogged with the electronic components and prevents the electronic components from flowing out all at once. A storage case 1 according to the present invention has a storage space S in which a component 50 is to be contained, and is attached to a feeder 100 which supplies the component 50 to a mounting device, said storage case 1 comprising: a component takeout port 6 that is provided in a side wall part 2F and that extends in the vertical direction when the storage case 1 is attached to the feeder 100; and an inclined surface 7a that is provided within the storage space S and that extends to a lower edge 6a of the component takeout port 6, which is at the bottom of the component takeout port 6 when the storage case 1 is attached to the feeder 100.

## Description

### TECHNICAL FIELD

The present invention relates to a storage case of electronic components.

### BACKGROUND ART

When mounting an electronic component on a board, a mounting device is used that installs and mounts the electronic component at a predetermined position on the board. To such a mounting device, electronic components need to be supplied individually.

An example of a method of individually supplying the electronic components to the mounting device is a tape feeder method of burying the electronic components inside a tape-shaped conveyor and taking out the components one by one. However, the tape feeder method generates waste such as tapes and tape covers.

On the other hand, another example of the method is a method of throwing together, into a storage case, electronic components in a bulk state, dropping the electronic components down to a feeder due to their own weights through a component takeout port formed in a bottom portion of the storage case, and individually supplying the components to the mounting device with the feeder (see Patent Document 1). In this method, no waste, such as tapes and tape covers, is generated.

Patent Document 1: Japanese Unexamined Patent Application, Publication No.2009-295618

### DISCLOSURE OF THE INVENTION

### Problems to be Solved by the Invention

However, when dropping down electronic components due to their own weights through a component takeout port formed in a bottom portion of a storage case and if the component takeout port in the bottom portion is large, the components flow out all at once.

On the other hand, when the component takeout port is reduced to set the number of electronic components flowing out per unit time to a desired number and when an amount of the electronic components in the storage case is large, clogging occurs at the component takeout port. For this reason, it is necessary to limit the electronic components to an amount that prevents the storage case from being easily clogged with the components.

However, if the amount of the electronic components is limited, the amount of the electronic components that can be thrown into the storage case might be small, which is not suitable for mass production.

It is an object of the present invention to provide a storage case that, regardless of the number of electronic components stored therein, prevents a component takeout port from being easily clogged with the electronic components and prevents the electronic components from flowing out all at once.

### Means for Solving the Problems

To achieve the above object, the present invention provides a storage case having a storage space in which a component is to be contained, the storage case being attached to a feeder that supplies the component to a mounting device, the storage case including: a component takeout port that is provided in a side wall part and that extends in a vertical direction when the storage case is attached to the feeder; and an inclined surface that is provided within the storage space and that extends to a lower edge of the component takeout port, which is on a lower side of the component takeout port when the storage case is attached to the feeder.

### Effects of the Invention

The present invention can provide a storage case that, regardless of the number of electronic components stored therein, prevents a component takeout port from being easily clogged with the electronic components and prevents the electronic components from flowing out all at once.

### BRIEF DESCRIPTION OF THE DRAWINGS

FIG. 1 is a perspective view of the storage case seen from a diagonally upper side, showing a state where a component takeout port is opened.
FIG. 2 is a perspective view showing an internal state of the storage case, showing the state where the component takeout port is opened.
FIG. 3 is a perspective view showing the internal state of the storage case, showing a state where the component takeout port is closed.
FIG. 4 is a perspective view of the storage case seen from a diagonally lower side, showing the state where the component takeout port is closed.
Fig. 5 shows explanatory views of a method of attaching the storage case to a feeder.

### PREFERRED MODE FOR CARRYING OUT THE INVENTION

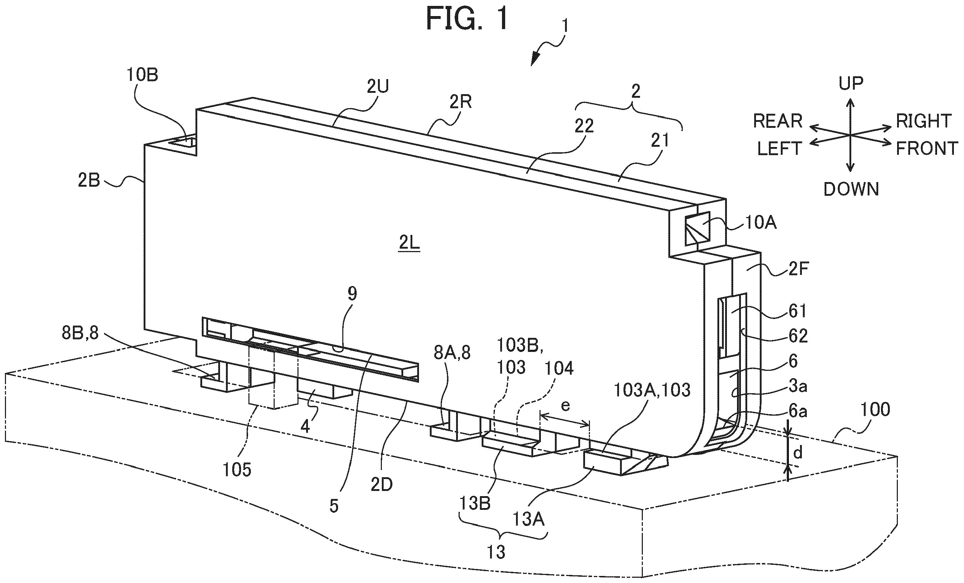

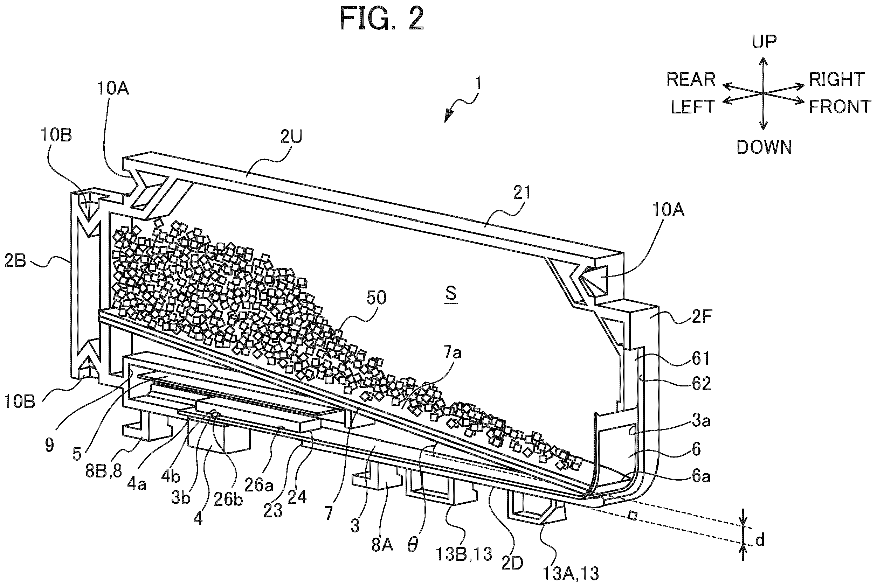

Hereinafter, a storage case 1 of an embodiment of the present invention will be described with reference to the drawings. FIG. 1 is a perspective view of the storage case 1 seen from a diagonally upper side. The storage case 1 is attachable to and detachable from a feeder 100 indicated by a dotted line, in which electronic components 50 (illustrated in FIG. 2) are stored in a bulk state as an example of components inside. The feeder 100 is a device that supplies, to a mounting device (not illustrated), the electronic components 50 flowing out of the storage case 1.

In the embodiment, each of the electronic components 50 is a capacitor, an inductor, or the like, and has a length of 1.2 mm or less in a longitudinal direction. The electronic component 50 has a shape of a substantially rectangular parallelepiped.

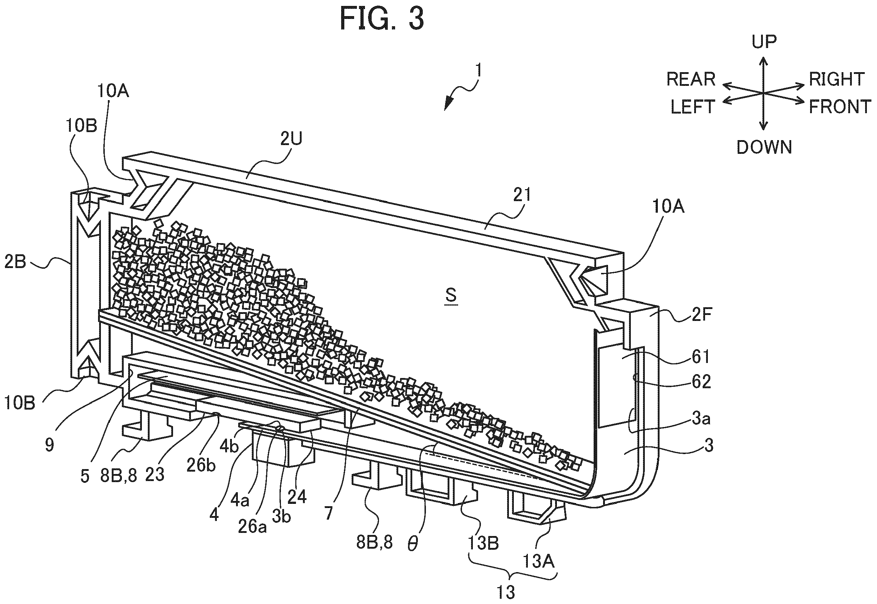

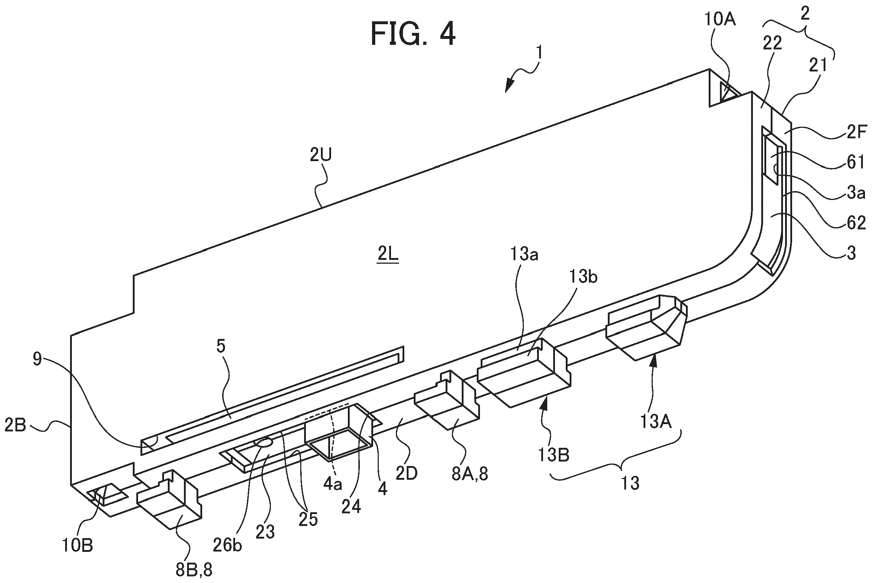

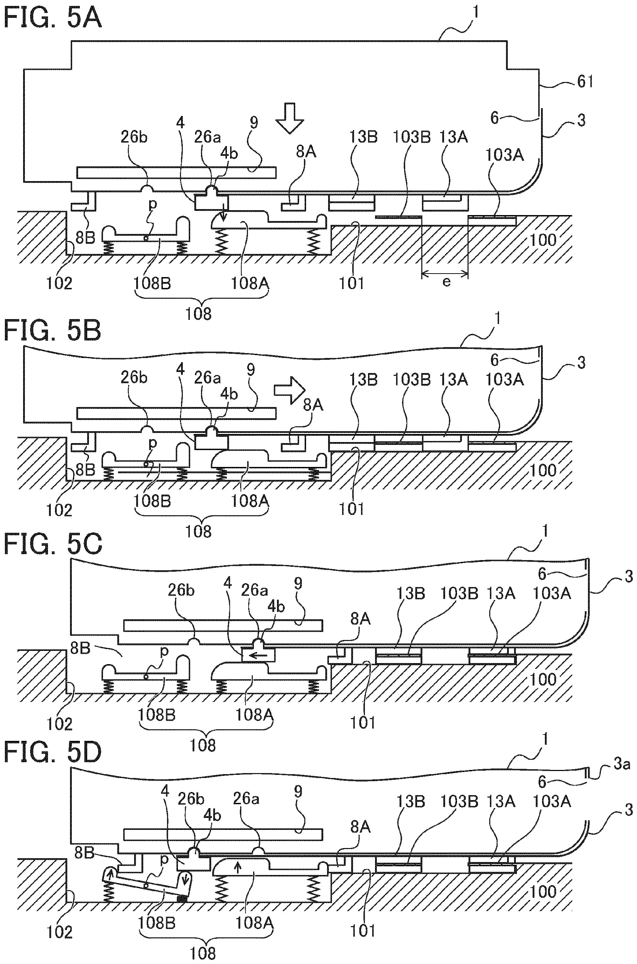

FIG. 2 is a perspective view showing an internal state of the storage case 1 from which an after-mentioned second side wall part 22 is removed, showing a state where a component takeout port 6 is opened. FIG. 3 is a perspective view showing the internal state of the storage case 1 from which the after-mentioned second side wall part 22 is removed in the same manner as in FIG. 2, showing the state where the component takeout port 6 is closed. FIG. 4 is a perspective view of the storage case 1 seen from a diagonally lower side. Fig. 5 shows explanatory views of a method of attaching the storage case 1 to the feeder 100.

### (Storage Case 1)

The storage case 1 includes a case body 2, a cover member 3, a drive unit 4, and an RFID tag 5.

### (Case Body 2)

The case body 2 is a container including a first side wall part 21 and the second side wall part 22, and the first side wall part 21 and the second side wall part 22 are assembled to form a storage space S inside. The case body 2 includes an upper wall part 2U, a bottom wall part 2D, a front wall part 2F, a rear wall part 2B, a right wall part 2R on a first side wall part 21 side, and a left wall part 2L on a second side wall part 22 side. Inside the storage case 1, the electronic components 50 are stored in a bulk state.

In the present description, when the storage case 1 is attached to the feeder 100, up and down directions of a vertical direction are up and down of the storage case 1. Further, in the storage case 1, a side on which the component takeout port 6 is provided is a front side and the opposite side is a rear side. A right side of the storage case 1 when seen from the front is the right and a left side is the left. The first side wall part 21 is located on the right side, and the second side wall part 22 is located on the left side.

The front wall part 2F, the rear wall part 2B, the right wall part 2R and the left wall part 2L are side wall parts extending in the vertical direction, that is, up and down. The upper wall part 2U and the bottom wall part 2D are wall parts extending in a horizontal direction.

### (Component Takeout Port 6)

The component takeout port 6 is provided on a lower side of the front wall part 2F of the case body 2. The component takeout port 6 is a quadrangular opening in the embodiment, but is not limited to a quadrangular shape, and may be an opening having another shape, for example, a circular shape or an elliptical shape. A position of a lower edge 6a when the component takeout port 6 is opened is spaced apart by a predetermined distance d = 3 mm to 6 mm from a bottom surface of the bottom wall part 2D on a feeder 100 side to the upper side in the vertical direction.

### (Inclined Surface 7a)

In the storage space S, a plate member 7 extends between the first side wall part 21 and the second side wall part 22. An upper surface of the plate member 7 is an inclined surface 7a that extends from the rear toward the lower edge 6a of the component takeout port 6 in front and that is inclined with a lower edge 6a side being a lowermost side.

An inclination angle θ of the inclined surface 7a is from 3° to 10° with respect to the horizontal direction when the storage case 1 is fitted to the feeder 100 and is 5° in the embodiment. The angle is even better from 5° to 7°.

### (Cover Member 3)

The cover member 3 covering the component takeout port 6 extends continuously from the bottom wall part 2D to the front wall part 2F. The cover member 3 is a long strip-shaped member, and a material is not limited thereto, but is polyethylene terephthalate (PET) in the embodiment and is a bendable material having rigidity to a certain degree. A width of the cover member 3 is slightly larger than a width of the component takeout port 6 and is a width that can cover the component takeout port 6 without any gaps. The width is from 1.0 × 10^6 to 1.0 × 10^12 (1.0 × 10⁶ to 1.0 × 10¹²). If it falls below 1.0 × 10^6, component damage due to a voltage rapidly occurs, and if it exceeds 1.0 × 10^12, component adhesion due to static electricity occurs.

The cover member 3 has a front end provided with an opening 3a having about the same shape as the component takeout port 6. The opening 3a does not need to have the same shape as the component takeout port 6, but an opening that penetrates when the opening 3a and the component takeout port 6 overlap becomes an outlet of the electronic component 50.

### (Guide Groove 62)

On the other hand, a cover part sliding concave portion 61 recessed from outside toward inside is provided on the upper side of the component takeout port 6 in the front wall part 2F of the case body 2.

Guide grooves 62 extending up and down are provided on the left and right of a side surface of a part provided with the component takeout port 6 and the cover part sliding concave portion 61 in a thickness direction of the front wall part 2F.

A difference between a width of each guide groove 62 and a thickness of the cover member 3 is from 50 um to 80 um. Opposite sides of the cover member 3 extending in the longitudinal direction are inserted into the left and right guide grooves 62. The cover member 3 is guided by the guide grooves 62 and slides along the front wall part 2F in an up-down direction.

### (Drive Unit 4)

The cover member 3 has a rear end provided with a circular hole 3b shown in FIGS. 2 and 3. The drive unit 4 that drives and slides the cover member 3 is fitted to the hole 3b. The drive unit 4 is a rectangular member and has a flange portion 4a extending outward to the left and right on the upper side. A convex portion 4b is provided on an upper surface of the drive unit 4, and the convex portion 4b is inserted into the hole 3b of the cover member 3 and protrudes upward.

On the other hand, as shown in FIG. 4, a drive unit sliding concave portion 23 recessed from the outside toward the inside is provided on the bottom wall part 2D of the storage case 1. On a front surface of the drive unit sliding concave portion 23, a long hole 24 is provided into which the cover member 3 can be inserted from an inner surface side to an outer surface side of the bottom wall part 2D. The cover member 3 extends through the long hole 24 to the outer surface side that is a bottom surface of the drive unit sliding concave portion 23. On an outer surface of the drive unit sliding concave portion 23, two recesses 26a and 26b are provided alongside in front and rear.

On side surfaces of a part provided with the drive unit sliding concave portion 23 in the thickness direction of the bottom wall part 2D, driving groove portions 25 extending in front and rear as shown in FIG. 4 are provided on the left and right. The flange portion 4a of the drive unit 4 is inserted between the left and right driving groove portions 25. When the drive unit 4 is moved back and forth by an operator or another device, the drive unit is guided by the driving groove portions 25 and slides in the drive unit sliding concave portion 23 in a front-rear direction. At this time, a slide range of the drive unit 4 is between a position where the convex portion 4b fits into the front recess 26a and a position where the convex portion fits into the rear recess 26b.

FIG. 5 will be described later in detail. As shown in FIGS. 5(c) and 3, when the convex portion 4b of the drive unit 4 is in the front recess 26a, the opening 3a of the cover member 3 is located in the cover part sliding concave portion 61 and does not overlap with the component takeout port 6. The whole component takeout port 6 is closed, and the electronic component 50 is not released to the outside.

As shown in FIGS. 5(d) and 2, when the convex portion 4b of the drive unit 4 is in the rear recess 26b, the opening 3a of the cover member 3 overlaps with the component takeout port 6 and opens the component takeout port 6. The electronic component 50 can be taken out.

### (Gripping Part 10)

On rear and upper sides of the case body 2, gripping parts 10 are provided. The gripping part 10 is provided in two types, an upper gripping part 10A and a rear gripping part 10B in the embodiment, but is not limited thereto, and may be one of them, or may be provided at other places, such as left and right, or up and down in front.

The upper gripping part 10A includes recesses provided at both front and rear ends of the upper side of the case body 2. The rear gripping part includes recesses provided at both upper and lower ends of the rear side of the case body 2. The gripping part 10 is used, for example, during conveying, because the part is gripped with a robot hand or the like.

### (RFID Tag 5)

The case body 2 further includes a through hole 9 that penetrates left and right downward. The RFID tag 5 is stuck to an inner upper surface of the through hole 9. The RFID tag 5 is a known one having a transmission/reception unit, a memory, an antenna, and the like. Note that the hole does not necessarily have to be the through hole and may only be able to contain the RFID tag, and the RFID tag may be affixed to the case body.

On the other hand, as shown in FIG. 1, a reader/writer 105 is fitted on the feeder 100 side. The reader/writer 105 can read or write information on the RFID tag 5 when the storage case 1 is attached to the feeder 100.

The case body 2 is further provided with a part to be locked 8 and a T-shaped slot part 13 that extend downward from the outer surface of the bottom wall part 2D.

### (Part to be locked 8)

The part to be locked 8 may be provided in two parts, a front part to be locked 8A and a rear part to be locked 8B in the embodiment, but is not limited thereto, and may be one. Hereinafter, portions common to the front part to be locked 8A and the rear part to be locked 8B will be collectively described as the part to be locked 8.

The part to be locked 8 extends from top to bottom, has a lower end bent rearward at substantially 90° and has an L-shape in a cross section extending up, down, left and right.

### (T-shaped Slot Part 13)

The T-shaped slot part 13 includes two parts of a front T-shaped slot part 13A and a rear T-shaped slot part 13B in the embodiment, but is not limited thereto, and may be one. However, by dividing the part into a plurality of parts, a slide distance of the storage case 1 when attached to the feeder 100 can be shortened. Hereinafter, common portions to the front T-shaped slot part 13A and the rear T-shaped slot part 13B will be collectively described as the T-shaped slot part 13.

As shown in FIG. 4, the T-shaped slot part 13 includes a thin neck portion 13a extending from top to bottom, and a wide portion 13b provided further below the thin neck portion 13a and has a T-shape in a cross section extending up, down, left and right.

### (Feeder 100 Side)

On the other hand, as shown in FIG. 5, the feeder 100 is provided with a first attaching concave portion 101 and a second attaching concave portion 102 recessed downward from an upper surface of the feeder 100.

### (First Attaching Concave Portion 101)

The first attaching concave portion 101 provided in the front has a left-right width that is a width in which the wide portion 13b of the T-shaped slot part 13 can be inserted and has an up-down depth that is larger than a length of the wide portion 13b in the up-down direction and that is smaller than a length of the whole front T-shaped slot part 13A in the up-down direction.

In two upper locations of the first attaching concave portion 101, the wide portion 13b of the T-shaped slot part is not insertable, but the thin neck portion 13a is provided with a pressing plate part 103 provided with a slit 104 having an insertable width as shown in FIG. 1. An upper surface of the pressing plate part 103 is a horizontal surface continuous from the upper surface of the feeder 100 and is provided with a front pressing plate part 103A and a rear pressing plate part 103B. A front-rear length of a gap e between the front pressing plate part 103A and the rear pressing plate part 103B shown in FIG. 5(a) is a length into which the front T-shaped slot part 13A can be inserted.

### (Lock Part 108)

The second attaching concave portion 102 is deeper than the first attaching concave portion 101, and a lock part 108 is provided inside. In the embodiment, the lock part 108 includes a front lock part 108A and a rear lock part 108B corresponding to the front part to be locked 8A and the rear part to be locked 8B, respectively.

### (Front Lock Part 108A)

The front lock part 108A is a plate-shaped member provided with front and rear protrusions directed upward. A front and rear of a bottom surface of the front lock part 108A are fitted via springs relative to a bottom portion of the second attaching concave portion 102. The front lock part 108A can be moved up and down by this spring.

### (Rear Lock Part 108B)

The rear lock part 108B is a plate-shaped member provided with front and rear protrusions directed upward. A front and rear of a bottom surface of the rear lock part 108B are fitted via springs relative to the bottom portion of the second attaching concave portion 102. A central portion of the rear lock part 108B is pivotally supported on a shaft p extending to the left and right. The rear lock part 108B can swing about the shaft.

### (Attaching Operation)

Next, an operation of attaching the storage case 1 to the feeder 100 will be described.

Inside the storage case 1, a large number of electronic components 50 are stored in a bulk state, and the component takeout port 6 is closed. At this time, the convex portion 4b of the drive unit 4 is in the front recess 26a, and the whole component takeout port 6 is closed with the opening 3a of the cover member 3.

As indicated by a white arrow in FIG. 5(a), the storage case 1 in this state is brought close to the feeder 100 side so that the front T-shaped slot part 13A of the storage case 1 is inserted into the gap between the front pressing plate part 103A and the rear pressing plate part 103B.

Then, from the gap e between the front pressing plate part 103A and the rear pressing plate part 103B, the front T-shaped slot part 13A of the storage case 1 is inserted into the first attaching concave portion 101. At the same time, the rear T-shaped slot part 13B of the storage case 1 is inserted into the first attaching concave portion 101 from behind the rear pressing plate part 103B.

At this time, the front lock part 108A is pushed by the drive unit 4 and pressed down against a spring force. The front lock part 108A descends as a whole without rotating.

Next, the storage case 1 is entirely slid to the front as indicated by a white arrow in FIG. 5(b).

Then, the front T-shaped slot part 13A and the rear T-shaped slot part 13B slide along a bottom surface of the first attaching concave portion 101. The wide portion 13b of the front T-shaped slot part 13A enters below the front pressing plate part 103A, and the wide portion 13b of the rear T-shaped slot part 13B enters below the rear pressing plate part 103B. Thereby, the storage case 1 is fixed to the feeder 100.

The storage case 1 is positioned on the feeder 100 when a front surface of the front T-shaped slot part 13A abuts on a front surface of the first attaching concave portion 101.

In this state, the reader/writer 105 shown in FIG. 1 can read the information on the RFID tag 5. Since the RFID tag 5 is disposed inside the through hole 9, the tag is hard to peel off and is hard to be damaged even during transportation and the like. An information containing unit may be described with a barcode including two dimensions, or an identification character or mark. Information corresponding to the identification character or mark may be held on a reading side, and the identification character or mark provided in the information containing unit is read and then connected to the data contained on the reading side, so that the electronic components and information contained in the present case are transmitted to the feeder 100 side.

Next, when the drive unit 4 is moved rearward as shown in FIG. 5(c), the opening 3a of the cover member 3 overlaps with the component takeout port 6, and the component takeout port 6 opens.

At this time, as shown in FIG. 5(d), the front protrusion of the rear lock part 108B is pushed downward by the drive unit 4. The rear lock part 108B rotates about the shaft p and the rear protrusion of the rear lock part 108B rises. The rear protrusion abuts on an L-shaped rear end of the rear part to be locked 8B.

Moreover, when the drive unit 4 moves rearward, the pressing of the front lock part 108A that has been pressed by the drive unit 4 is released. Then, the front lock part 108A rises due to a restoring force of the spring, and a protrusion at a front end of the front lock part 108A abuts on an L-shaped rear end of the front part to be locked 8A.

In this way, the rear lock part 108B locks the rear part to be locked 8B, and the front lock part 108A locks the front part to be locked 8A. Therefore, when the cover member 3 opens the component takeout port 6, the storage case 1 is not removed from the feeder 100.

In this state, the electronic component 50 slides down along the inclined surface 7a and is released from the component takeout port 6. At this time, the number of the electronic components 50 flowing out per unit time can be controlled by the angle of the inclined surface 7a, and hence a supply speed of the electronic component 50 can be controlled.

The released electronic component 50 is conveyed to a predetermined place by a conveying unit (not shown) provided in the feeder 100.

Unlike the embodiment, when the electronic components 50 fall down due to their own weights in the vertical direction, the component falls down all at once. Therefore, the component takeout port 6 might be clogged with the electronic components 50.

However, in the embodiment, since the number of the electronic components 50 flowing out per unit time can be controlled, regardless of the number of the electronic components 50 stored therein, the component takeout port 6 is not easily clogged with the electronic components 50 and the electronic components do not flow out all at once.

Further, a thickness of the electronic component 50 in the thinnest direction is, for example, from 90 um to 700 um and is larger than a range of 50 um to 80 µm, which is a difference between the width of the guide groove 62 and the thickness of the cover member 3. Therefore, when the electronic components 50 are released, any electronic components do not enter a gap between the guide groove 62 and the cover member 3. The length of the electronic component 50 in the longitudinal direction more preferably has a size of 180 um to 330 µm.

In the embodiment, a position of the lower edge 6a when the component takeout port 6 is opened is spaced apart by the predetermined distance d from the bottom surface of the bottom wall part 2D on the feeder 100 side to the upper side in the vertical direction. Therefore, the electronic component 50 that has flowed out does not flow backward to the component takeout port 6 from the unillustrated conveying unit on the feeder 100 on which the component falls down.

When the component takeout port 6 is opened, as shown in FIG. 2, at least the lower edge 6a of the component takeout port 6 is above a lower edge of the opening 3a of the cover member 3. Therefore, when the electronic component 50 flows out, the component is caught on the lower edge of the opening 3a of the cover member 3 and is not hindered from flowing out.

Since the storage case 1 of the embodiment is provided with the gripping part 10, the case can be set on the feeder 100 by use of an automatic robot arm or the like.

Since the case body 2 includes the RFID tag 5 and the reader/writer 105 is fitted on the feeder 100 side, the reader/writer 105 can read the information on the RFID tag 5. Therefore, it is easy to manage the electronic component 50 in the storage case 1.

### (Modified Forms)

As above, the suitable embodiment of the present invention has been described, but is not limited thereto, and can be variously changed.
(1) For example, in the embodiment, the T-shaped slot part 13 is provided and the first attaching concave portion 101 is provided in the feeder 100, which is not limited thereto. The T-shaped slot part may be provided in the feeder, and a first concave portion may be provided in the storage case.
   Further, the part to be locked 8 is provided in the storage case 1 and the lock part 108 is provided in the feeder 100, which is not limited thereto. The part to be locked may be provided in the feeder 100 and the lock part may be provided in the storage case 1.
(2) A vibration device that vibrates the storage case 1 may be provided separately in the feeder 100. In this case, for example, when a release rate of the electronic component 50 lowers, the storage case 1 can be vibrated by the vibration device to improve the release rate.
(3) In the embodiment, the inclined surface 7a is a flat surface, but is not limited thereto, and may be a curved surface or the like. In this case, a curve may be provided in a vertical front-to-rear cross section, or a curve may be provided in a vertical left-to-right cross section. Further, a combination of straight lines having different inclinations may be provided in the vertical front-to-rear cross section and the vertical left-to-right cross section. Furthermore, a combination of these curve and straight line may be provided.
(4) A structure of the lock part and the part to be locked is not limited to such a structure as in the embodiment. Another structure may be provided as long as the removal of the storage case 1 from the feeder 100 is regulated when the component takeout port 6 is opened.
(5) The RFID tag 5 may be disposed at a location other than the through hole 9. Further, in place of the RFID tag 5, a medium in which externally readable information is recorded may be disposed.

### EXPLANATION OF REFERENCE NUMERALS

- θ: inclination angle
- S: storage space
- 1: storage case
- 2: case body
- 2D: bottom wall part
- 2F: front wall part
- 3: cover member
- 3a: opening
- 4: drive unit
- 5: RFID tag
- 6: component takeout port
- 6a: lower edge
- 7a: inclined surface
- 8: part to be locked
- 10: gripping part
- 13: T-shaped slot part
- 21: first side wall part
- 22: second side wall part
- 25: driving groove portion
- 50: electronic component
- 62: guide groove
- 100: feeder
- 108: lock part

## Claims

1. A storage case having a storage space in which a component is to be contained, the storage case comprising:
a component takeout port that is provided in a side wall part, and
an inclined surface that is provided within the storage space and that extends toward the component takeout port.

2. The storage case according to claim 1,
wherein the inclined surface is inclined at an angle of 3° to 10° with respect to a horizontal direction when the storage case is attached to a feeder and so that a side of a lower edge of the component takeout port which is a lower side when the storage case is attached to the feeder is a lower side in a vertical direction.

3. The storage case according to claim 2,
wherein the lower edge of the component takeout port is provided to be spaced apart from a bottom surface of the storage case to an upper side in the vertical direction.

4. The storage case according to any one of claims 1 to 3,
wherein a gripping part is provided on an outer wall part of the storage case.

5. The storage case according to any one of claims 1 to 4, comprising:
a cover member that slides along the component takeout port to open and close the component takeout port; and
a guide groove that is formed in the side wall part provided with the component takeout port and that guides slide movement of the cover member,
wherein a difference between a width of the guide groove and a thickness of the cover member is from 50 um to 80 pm.

6. The storage case according to claim 5, comprising
a drive unit that drives and slides the cover member, in an outer wall part other than the side wall part provided with the component takeout port.

7. The storage case according to any one of claims 1 to 6,
wherein a part to be locked is provided in one of the storage case or a feeder, and
a lock part, which engages with the part to be locked to lock the storage case to the feeder in a state where the storage case is attached to the feeder, is provided in the other of the storage case or the feeder.

8. The storage case according to any one of claims 1 to 7,
wherein an information containing unit is provided in the storage case.

9. The storage case according to any one of claims 1 to 8,
wherein a length of the component in a longitudinal direction is 1.2 mm or less.
